# EUROPÄISCHE PATENTSCHRIFT

(11) **EP 3 881 654 B1**
(45) Veröffentlichungstag und Bekanntmachung des Hinweises auf die Patenterteilung: **29.03.2023**
(21) Anmeldenummer: 19805566.7
(22) Anmeldetag: 11.11.2019
(51) Int. Cl.: H05K 3/00, H05K 3/40, H01L 33/48, H05K 1/18, H05K 1/03, H01L 33/62, H01L 25/075, G09F 9/33

(54) **VERFAHREN ZUR HERSTELLUNG EINER VIELZAHL STRAHLUNGSEMITTIERENDER BAUELEMENTE, STRAHLUNGSEMITTIERENDES BAUELEMENT, VERFAHREN ZUR HERSTELLUNG EINES VERBINDUNGSTRÄGERS UND VERBINDUNGSTRÄGER**
METHOD FOR PRODUCING A PLURALITY OF RADIATION-EMITTING COMPONENTS, RADIATION-EMITTING COMPONENT, METHOD FOR PRODUCING A CONNECTION CARRIER, AND CONNECTION CARRIER
PROCÉDÉ DE FABRICATION D'UNE PLURALITÉ DE COMPOSANTS ÉLECTROLUMINESCENTS, COMPOSANT ÉLECTROLUMINESCENT, PROCÉDÉ DE FABRICATION D'UN SUPPORT DE CONNEXION ET SUPPORT DE CONNEXION

(30) Priorität: 14.11.2018 DE 102018128570
(43) Veröffentlichungstag der Anmeldung: 22.09.2021
(73) Patentinhaber: OSRAM Opto Semiconductors GmbH, 93055 Regensburg (DE)
(72) Erfinder: WITTMANN, Sebastian, 93051 Regensburg (DE); PERZLMAIER, Korbinian, 93055 Regensburg (DE)
(74) Vertreter: Epping - Hermann - Fischer
(86) Internationale Anmeldenummer: PCT/EP2019/080873
(87) Internationale Veröffentlichungsnummer: WO 2020/099324

(56) Entgegenhaltungen:
- WO-A1-2014/120256
- WO-A2-2008/020191
- DE-U1-202017 106 116
- US-A1- 2012 244 651

## Beschreibung

Es werden ein Verfahren zur Herstellung einer Vielzahl strahlungsemittierender Bauelemente und ein Verfahren zur Herstellung eines Verbindungsträgers angegeben.

Die Druckschrift WO 2014/120256 A1 betrifft ein oberflächenmontierbare, Licht emittierende Komponente und ein Verfahren.

Die Druckschrift DE 202017106116 U1 beschreibt eine Dreieckskombination-LED-Leiterplatte, eine dreieckige LED-Vorrichtung und eine Anzeige.

Die Druckschrift WO 2008/020191 A2 offenbart ein Verfahren zum anisotropen Plasmaätzen eines Halbleiterwafers.

Die Druckschrift US 2012/0244651 A1 betrifft ein Verfahren zur Herstellung einer Leuchtdiode.

Es sollen ein vereinfachtes Verfahren zur Herstellung eines Verbindungsträgers und ein vereinfachtes Verfahren zur Herstellung eines strahlungsemittierenden Bauelements mit einem Verbindungsträger angegeben werden.

Diese Aufgaben werden durch ein Verfahren mit den Schritten des Patentanspruchs 1 und durch ein Verfahren mit den Schritten des Patentanspruchs 8 gelöst.

Vorteilhafte Ausführungsformen und Weiterbildung der beiden Verfahren sind Gegenstand der jeweils abhängigen Ansprüche.

Gemäß einer Ausführungsform des Verfahrens zur Herstellung einer Vielzahl strahlungsemittierender Bauelemente wird ein Verbund mit einer Vielzahl von Verbindungsträgern bereitgestellt.

Bevorzugt weist jeder Verbindungsträger eine lichtdurchlässige Matrix auf. Die lichtdurchlässige Matrix ist besonders bevorzugt durchlässig für sichtbares Licht. Hierbei transmittiert die lichtdurchlässige Matrix bevorzugt 85 % und besonders bevorzugt mindestens 95 % des sichtbaren Lichts. Die lichtdurchlässige Matrix weist bevorzugt Glas auf oder ist aus Glas gebildet.

In der lichtdurchlässigen Matrix jedes Verbindungsträgers sind bevorzugt Durchkontaktierungen angeordnet, die sich von einer ersten Hauptfläche des Verbindungsträgers zu einer zweiten Hauptfläche des Verbindungsträgers hindurch erstrecken. Mit anderen Worten durchdringen die Durchkontaktierungen die lichtdurchlässige Matrix besonders bevorzugt vollständig. Die Durchkontaktierungen sind bevorzugt an der ersten Hauptfläche und/oder der zweiten Hauptfläche des Verbindungsträgers in lateraler Richtung nicht von der Matrix überdeckt. Besonders bevorzugt ist der thermische Ausdehnungskoeffizient der Matrix an dem thermischen Ausdehnungskoeffizienten der Durchkontaktierungen angepasst.

Die Durchkontaktierungen können unterschiedliche Geometrien aufweisen. Insbesondere muss eine Querschnittsfläche der Durchkontaktierungen nicht notwendigerweise rund oder kreisförmig ausgebildet sein. Seitenwände der Durchkontaktierungen können hierbei senkrecht auf den Hauptflächen des Verbindungsträgers stehen. Weiterhin ist es auch möglich, dass die Seitenwände einen anderen Winkel als 90° mit den Hauptflächen des Verbindungsträgers einschließen. Beispielsweise weisen die Durchkontaktierungen eine konische Form auf.

Gemäß einer weiteren Ausführungsform sind die Verbindungsträger durch Rahmen voneinander beabstandet. Die Rahmen umlaufen hierbei jeden Verbindungsträger besonders bevorzugt vollständig. Besonders bevorzugt wird jeder Verbindungsträger von einem Rahmen umlaufen. Besonders bevorzugt grenzen die Rahmen direkt benachbarter Verbindungsträger direkt aneinander an. Beispielsweise sind die Rahmen direkt benachbarter Verbindungsträger in dem Verbund einstückig ausgebildet. Bevorzugt sind die Rahmen aus dem gleichen Material gebildet wie die Durchkontaktierungen.

Gemäß einer Ausführungsform ist der Verbund aus einer Vielzahl an Verbindungsträgern und einer Vielzahl an Rahmen gebildet, wobei bevorzugt jeder Verbindungsträger von einem Rahmen umlaufen wird.

Die Durchkontaktierungen sind besonders bevorzugt elektrisch leitend ausgebildet. Beispielsweise weisen die Durchkontaktierungen und/oder die Rahmen ein Halbleitermaterial auf. Besonders bevorzugt weisen die Durchkontaktierungen und/oder die Rahmen Silizium auf. Das Halbleitermaterial, beispielsweise das Silizium, ist besonders bevorzugt hoch n-dotiert oder hoch p-dotiert. Die Durchkontaktierungen sind bevorzugt dafür vorgesehen, strahlungsemittierende Halbleiterchips elektrisch zu kontaktieren. Dies wird insbesondere durch ein hochdotiertes Halbleitermaterial, wie ein hochdotiertes Silizium, ermöglicht.

Gemäß einer weiteren Ausführungsform des Verfahrens wird ein strahlungsemittierender Halbleiterchip auf zwei Durchkontaktierungen angeordnet. Besonders bevorzugt wird der strahlungsemittierende Halbleiterchip elektrisch leitend mit den beiden Durchkontaktierungen verbunden.

Weiterhin ist es auch möglich, dass der strahlungsemittierende Halbleiterchip nur auf einer oder keiner Durchkontaktierung angeordnet wird. Die elektrische Verbindung des strahlungsemittierenden Halbleiterchips mit einer Durchkontaktierung kann in diesem Fall über eine metallische Schicht erzeugt werden.

Beispielsweise handelt es sich bei dem strahlungsemittierenden Halbleiterchip um eine Leuchtdiode oder ein oberflächenemittierendes VCSEL (kurz für englisch "vertical cavity surface emitting laser"). Der strahlungsemittierende Halbleiterchip sendet besonders bevorzugt sichtbares Licht aus, beispielsweise rotes Licht, grünes Licht, ultraviolettes Licht und/oder blaues Licht. Weiterhin ist es auch möglich, dass der strahlungsemittierende Halbleiterchip infrarotes Licht aussendet. Neben einem strahlungsemittierenden Halbleiterchip kann auch ein elektronischer Halbleiterchip in dem Bauelement eingesetzt werden, der als Sensor dient. Bei dem Sensor kann es sich um eine Fotodiode, eine Kamera oder einen Temperatursensor handeln.

Gemäß einer besonders bevorzugten Ausführungsform werden die Bauelemente durch vollständiges oder teilweises Entfernen der Rahmen vereinzelt.

Gemäß einer weiteren Ausführungsform des Verfahrens umfasst das Bereitstellen des Verbunds die im Folgenden beschriebenen Schritte. Der so erzeugte Verbund weist insbesondere eine Glasmatrix als lichtdurchlässige Matrix und ein Halbleitermaterial für die Rahmen und die Durchkontaktierungen auf. Der Verbund kann auch als Glashalbleiterverbund bezeichnet werden.

Zunächst wird ein Halbleiterwafer bereitgestellt und mit Ausnehmungen strukturiert. Die Ausnehmungen weisen beispielsweise eine Tiefe zwischen einschließlich 50 Mikrometer und einschließlich 300 Mikrometer auf. Bevorzugt weisen die Ausnehmungen eine Tiefe zwischen einschließlich 120 Mikrometer und einschließlich 250 Mikrometer auf.

Das Strukturieren des Halbleiterwafers kann beispielsweise mittels Ätzen unter Verwendung einer Fotolackmaske erfolgen. Die Ausnehmungen gehen bevorzugt von einer ersten Hauptfläche des Halbleiterwafers aus, durchtrennen den Halbleiterwafer aber bevorzugt nicht vollständig. In den Ausnehmungen sind bevorzugt Pfosten angeordnet, die ausgehend von einer zweiten Hauptfläche des Halbleiterwafers, die der ersten Hauptfläche gegenüberliegt, durch Material des Halbleiterwafers miteinander kontinuierlich verbunden sind. Die Pfosten bilden besonders bevorzugt die späteren Durchkontaktierungen aus. Die Ausnehmungen werden in einem nächsten Schritt bevorzugt mit Glas gefüllt. Besonders bevorzugt erfolgt das Füllen der Ausnehmungen mit Glas durch Aufschmelzen eines Glaswafers, sodass der Verbund entsteht. Der Glaswafer wird hierzu bevorzugt auf die erste Hauptfläche des Halbleiterwafers aufgebracht und erhitzt. Die Rahmen dienen hierbei mit Vorteil dazu, den strukturierten Halbleiterwafer während des Füllens der Ausnehmungen mit Glas zu stabilisieren.

Gemäß einer weiteren Ausführungsform wird der Verbund gedünnt, sodass die Vielzahl an Verbindungsträgern entsteht. Bevorzugt wird der Verbund ausgehend von der zweiten Hauptfläche gedünnt. Vor dem Dünnen des Verbundes ausgehend von der zweiten Hauptfläche kann der Verbund auch ausgehend von der ersten Hauptfläche aus gedünnt werden, beispielsweise um eine Dicke von ungefähr 50 Mikrometer. Nach dem Dünnen weist der Verbund beispielsweise eine Dicke zwischen einschließlich 80 Mikrometer und einschließlich 120 Mikrometer auf. Hierbei wird bevorzugt das Material des Halbleiterwafers, das die Pfosten miteinander kontinuierlich verbindet, vollständig entfernt. Hierbei entsteht bevorzugt eine Oberfläche, die durch die Matrix und die Durchkontaktierungen gebildet ist. Der Verbund weist nun bevorzugt zwei gegenüberliegende Hauptflächen auf, die jeweils bereichsweise durch die Matrix und bereichsweise durch die Durchkontaktierung gebildet ist.

Gemäß einer weiteren Ausführungsform des Verfahrens werden die beiden Hauptflächen des Verbunds nach dem Dünnen poliert, beispielsweise durch ein chemisch-mechanisches oder trockenes Polierverfahren. Mit Hilfe eines chemisch-mechanischen Polierverfahrens kann eine Topografie zwischen der Matrix und den Durchkontaktierungen auf gewünschte Art und Weise eingestellt werden. Beispielsweise können die Durchkontaktierungen gegenüber der Matrix zurückgesetzt sein.

Gemäß einer weiteren Ausführungsform des Verfahrens werden auf den Durchkontaktierungen elektrische Anschlussstellen angeordnet. Besonders bevorzugt wird auf jeder Durchkontaktierung eine elektrische Anschlussstelle angeordnet. Die elektrischen Anschlussstellen stehen hierbei besonders bevorzugt in direktem Kontakt mit der Durchkontaktierung. Besonders bevorzugt überdecken die elektrischen Anschlussstellen die Durchkontaktierungen vollständig. Beispielsweise sind die elektrischen Anschlussstellen aus einem Metall gebildet oder weisen ein Metall auf. Die elektrischen Anschlussstellen können Gold aufweisen oder aus Gold gebildet sein.

Gemäß einer weiteren Ausführungsform des Verfahrens werden die Rahmen durch Ätzen vollständig oder teilweise entfernt. Dies weist gegenüber Sägen oder Lasertrennen den Vorteil auf, dass auch Verbindungsträger mit vergleichsweise kleinen Abmessungen voneinander getrennt werden können. Die Verbindungsträger weisen beispielsweise eine Kantenlänge zwischen einschließlich 120 Mikrometer und einschließlich 250 Mikrometer auf.

Bei dem Ätzen kann es sich um anisotropes Ätzen oder isotropes Ätzen handeln. Beim isotropen Ätzen erfolgt ein Materialabtrag in der Regel nur wenig gerichtet. Bevorzugt erfolgt der Materialabtrag beim isotropen Ätzen gleich in alle Raumrichtungen. Isotropes Ätzen kann durch ein Gas, wie XeF₂ oder nasschemisch durch eine Flüssigkeit, wie KOH oder NaOH, erzielt werden. Das abgetragene Material wird beim isotropen Ätzen in einem Gas bevorzugt in die Gasphase überführt.

Beim anisotropen Ätzen erfolgt der Materialabtrag hingegen in der Regel gerichtet, also entlang einer Vorzugsrichtung. Anisotropes Ätzen kann durch ein Plasma, wie SF₆, erzielt werden.

Gemäß einer besonders bevorzugten Ausführungsform werden die elektrischen Anschlussstellen vor dem Ätzen auf den Durchkontaktierungen angeordnet. Die elektrischen Anschlussstellen überdecken die Durchkontaktierungen hierbei jeweils bevorzugt vollständig. Die Rahmen werden bei dieser Ausführungsform bevorzugt nach dem Aufbringen der elektrischen Anschlussstellen durch isotropes Ätzen mit Hilfe eines Gases oder einer Flüssigkeit vollständig oder teilweise entfernt. Hierbei wird mit Vorteil keine zusätzliche lithographische Maske verwendet, die die Durchkontaktierungen abdeckt. Vielmehr dienen die elektrischen Anschlussstellen auf den Durchkontaktierungen mit Vorteil zum Schutz der Durchkontaktierungen vor dem Gas oder der Flüssigkeit. Dies vereinfacht das Herstellungsverfahren.

Bei dieser Ausführungsform des Verfahrens werden die Seitenflächen der Verbindungsträger, die durch das vollständige oder teilweise Entfernen der Rahmen entstehen, bevorzugt vollständig aus der Matrix gebildet. Mit anderen Worten sind bei dieser Ausführungsform die Durchkontaktierungen in lateraler Richtung vollständig in einem Volumenbereich der Matrix angeordnet. Ein isotropes Ätzen kann beispielsweise in einem Gas, wie XeF₂ erfolgen. Auch eine Flüssigkeit kann für das isotrope Ätzen geeignet sein. Die Matrix ist bevorzugt im Wesentlichen inert für das Gas oder die Flüssigkeit.

Alternativ zu einem isotropen Ätzen mit Hilfe eines Gases oder einer Flüssigkeit kann auch ein anisotropes Ätzen mit Hilfe eines Plasmas zum vollständigen oder teilweisen Entfernen der Rahmen verwendet werden. Vorliegend wird beim anisotropen Ätzen besonders bevorzugt eine Maske verwendet. Die Maske überdeckt hierbei die Durchkontaktierungen bevorzugt so, dass die Maske die Durchkontaktierungen vor dem Plasma schützt. Die Rahmen sind hingegen frei zugänglich, so dass sie durch das Plasma entfernt werden können. Die Matrix ist bevorzugt im Wesentlichen inert für das Plasma.

Bei dieser Ausführungsform des Verfahrens können mit Vorteil Durchkontaktierungen gebildet werden, die teilweise die Seitenflächen der fertigen Verbindungsträger ausbilden. Mit anderen Worten ist das Material der Durchkontaktierungen in dem Verbund vor der Vereinzelung mit dem Material der Rahmen kontinuierlich verbunden. Durch den anisotropen Ätzprozess wird zwischen den Durchkontaktierungen und den Rahmen jeweils die Seitenfläche des Verbindungsträgers erzeugt. Diese Ausführungsform des Verfahrens weist den Vorteil auf, dass die Durchkontaktierungen direkt am Rand der Verbindungsträger angeordnet werden können, so dass eine besonders kompakte Ausbildung der fertigen strahlungsemittierenden Bauelemente mit den Verbindungsträgern erzielt werden kann.

Zum anisotropen Ätzen kann beispielsweise ein sogenannter Bosch-Prozess verwendet werden. Bei einem Bosch-Prozess wird in der Regel ein Trockenätzprozess mit einem Passivierungsschritt abgewechselt. Bei dem Trockenätzprozess wird das abzutragende Material entfernt, in der Regel isotrop. Nach einem gewissen Materialabtrag wird die durch den Trockenätzprozess freigelegte Oberfläche bei einem Passivierungsschritt mit einer Passivierungsschicht versehen. Danach erfolgt durch einen weiteren Trockenätzprozess ein weiterer Materialabtrag, wiederum in der Regel isotrop. Der Trockenätzprozess und der Passivierungsschritt werden alternierend ausgeführt bis das Material durchtrennt ist. Auf diese Art und Weise entsteht eine Seitenfläche mit Vereinzelungsspuren, die für den Bosch-Prozess charakteristisch sind. Die Vereinzelungsspuren weisen beispielsweise Einbuchtungen oder Sägezahnstrukturen als Strukturelemente auf. Die Einbuchtungen können muschelförmig ausgebildet sein. Insbesondere sind die Vereinzelungsspuren, die mit dem Bosch-Prozess erzeugt werden, in der Regel regelmäßig ausgebildet, das heißt es schließen sich gleiche oder ähnliche Strukturelemente in einer regelmäßigen Abfolge aneinander an. Wie oben beschrieben, sind die Vereinzelungsspuren typisch für den Bosch-Prozess, so dass an dem fertigen Verbindungsträger oder an dem fertigen Bauelement nachgewiesen werden kann, dass ein Bosch-Prozess zur Separation durchgeführt wurde.

Im Folgenden wird ein Verfahren zur Herstellung einer Vielzahl von Verbindungsträgern näher beschrieben, wobei die Verbindungsträger bevorzugt voneinander räumlich getrennt sind. Sämtliche in Verbindung mit dem Verfahren zur Herstellung einer Vielzahl von strahlungsemittierenden Bauelementen beschriebenen Merkmale und Ausführungsformen können auch bei dem Verfahren zur Herstellung einer Vielzahl räumlich voneinander getrennter Verbindungsträger ausgebildet sein und umgekehrt.

Das Verfahren zur Herstellung einer Vielzahl von Verbindungsträgern unterscheidet sich von dem Verfahren zur Herstellung einer Vielzahl strahlungsemittierender Bauelemente insbesondere dadurch, dass bei Ersterem keine strahlungsemittierende Halbleiterchips eingesetzt werden. Beispielsweise kann zunächst mit dem beschriebenen Verfahren eine Vielzahl an Verbindungsträgern hergestellt werden, die nachträglich mit Halbleiterchips bestückt werden. Weiterhin ist es auch möglich, dass die strahlungsemittierenden Halbleiterchips auf die Verbindungsträger während deren Herstellungsprozesses aufgebracht werden, wobei durch das vollständige oder teilweise Entfernen der Rahmen eine Vielzahl strahlungsemittierender Bauelemente entstehen.

Gemäß einer Ausführungsform des Verfahrens zur Herstellung einer Vielzahl räumlich voneinander getrennter Verbindungsträger wird zunächst ein Verbund mit einer Vielzahl an Verbindungsträgern bereitgestellt. Jeder Verbindungsträger weist bevorzugt eine lichtdurchlässige Matrix auf, in der Durchkontaktierungen angeordnet sind. Die Durchkontaktierungen erstrecken sich bevorzugt von einer ersten Hauptfläche des Verbindungsträgers zu einer zweiten Hauptfläche des Verbindungsträgers hindurch. Außerdem umfasst der Verbund bevorzugt eine Vielzahl an Rahmen. Die Verbindungsträger sind bevorzugt durch die Rahmen voneinander beabstandet. Jeder Verbindungsträger wird bevorzugt vollständig von einem Rahmen umlaufen. Gemäß einer Ausführungsform des Verfahrens werden die Verbindungsträger durch vollständiges oder teilweises Entfernen der Rahmen vereinzelt.

Mit dem hier beschriebenen Verfahren zur Herstellung einer Vielzahl an Verbindungsträgern und/oder strahlungsemittierenden Bauelementen ist es mit Vorteil möglich, auf effiziente Art und Weise Verbindungsträger oder Bauelemente mit Verbindungsträger zu erzeugen, bei denen ein möglichst großer Volumenanteil aus der lichtdurchlässigen Matrix gebildet ist. Dies erhöht die Effizienz eines strahlungsemittierenden Bauelements mit diesem Verbindungsträger.

Mit dem hier beschriebenen Verfahren kann eine Vielzahl an Verbindungsträger erzeugt werden, die bevorzugt räumlich voneinander getrennt sind. Merkmale und Ausführungsformen, die in Verbindung mit dem Verfahren zur Herstellung einer Vielzahl an Verbindungsträgern beschrieben sind, können auch bei dem Verbindungsträger ausgebildet sein und umgekehrt.

Der Verbindungsträger ist dazu vorgesehen, den strahlungsemittierenden Halbeiterchip mit einem Anschlussträger elektrisch leitend zu verbinden. Der Verbindungsträger ist dazu vorgesehen, einen Teil des strahlungsemittierenden Bauelements zu bilden. Sämtliche Ausführungsformen und Merkmale, die vorliegend in Verbindung mit dem strahlungsemittierenden Bauelement beschrieben sind, können auch bei dem Verbindungsträger ausgebildet sein und umgekehrt.

Gemäß einer Ausführungsform weist der Verbindungsträger eine lichtdurchlässige Matrix auf, in der Durchkontaktierungen angeordnet sind. Die Durchkontaktierungen erstrecken sich bevorzugt von einer ersten Hauptfläche des Verbindungsträgers zu einer zweiten Hauptfläche des Verbindungsträgers hindurch, wobei die zweite Hauptfläche der ersten Hauptfläche gegenüberliegt. Seitenflächen des Verbindungsträgers sind besonders bevorzugt durch die lichtdurchlässige Matrix und/oder die Durchkontaktierungen gebildet. Mit anderen Worten weisen die Seitenflächen des Verbindungsträgers bevorzugt kein anderes Material auf als das Material der Matrix und/oder das Material der Durchkontaktierungen.

Die Durchkontaktierungen sind in dem Verbindungsträger bevorzugt durch die lichtdurchlässige Matrix voneinander elektrisch isoliert. Die Matrix weist mit Vorteil eine vergleichsweise hohe dielektrische Konstante auf, sodass eine effektive elektrische Isolierung der Durchkontaktierungen voneinander mit Hilfe der Matrix möglich ist.

Mit dem oben beschriebenen Verfahren kann ein strahlungsemittierendes Bauelement erzeugt werden. Das strahlungsemittierende Bauelement wird im Folgenden näher beschrieben.

Das strahlungsemittierende Bauelement umfasst einen Verbindungsträger, der eine lichtdurchlässige Matrix aufweist. In der lichtdurchlässigen Matrix sind bevorzugt Durchkontaktierungen angeordnet, die sich von einer ersten Hauptfläche des Verbindungsträgers zu einer zweiten Hauptfläche des Verbindungsträgers hindurch erstrecken. Seitenflächen des Verbindungsträgers sind bevorzugt durch die lichtdurchlässige Matrix und/oder die Durchkontaktierungen gebildet. Weiterhin umfasst das strahlungsemittierende Bauelement besonders bevorzugt mindestens einen strahlungsemittierenden Halbleiterchip.

Der strahlungsemittierende Halbleiterchip kann in Draufsicht eine polygonale, beispielsweise dreieckige, rechteckige oder sechseckige Form aufweisen. Außerdem ist es möglich, dass der strahlungsemittierende Halbleiterchip in Draufsicht eine runde, beispielsweise kreisförmige Form aufweist.

Auch der Verbindungsträger kann in Draufsicht eine polygonale, beispielsweise dreieckige, rechteckige oder sechseckige Form aufweisen. Weist der Verbindungsträger eine polygonale Form, etwa rechteckige Form, in Draufsicht auf, so können die Ecken abgerundet sein. Außerdem ist es möglich, dass der Verbindungsträger in Draufsicht eine runde, beispielsweise kreisförmige Form aufweist.

Der strahlungsemittierende Halbleiterchip kann besonders bevorzugt mit Hilfe der zwei Durchkontaktierungen über die zweite Hauptfläche des Verbindungsträgers elektrisch kontaktiert werden. Die zweite Hauptfläche des Verbindungsträgers liegt hierbei der ersten Hauptfläche des Verbindungsträgers gegenüber, auf der die Halbleiterchips angeordnet sind.

Das strahlungsemittierende Bauelement umfasst weiterhin mindestens einen strahlungsemittierenden Halbleiterchip, der elektromagnetische Strahlung aus dem sichtbaren Spektralbereich aussendet. Weiterhin ist es möglich, dass der strahlungsemittierende Halbleiterchip infrarote Strahlung aussendet. Bei dem strahlungsemittierenden Halbleiterchip kann es sich auch um ein VCSEL handeln.

Besonders bevorzugt umfasst das strahlungsemittierende Bauelement mindestens einen rot emittierenden Halbleiterchip, mindestens einen grün emittierenden Halbleiterchip und mindestens einen blau emittierenden Halbleiterchip. Mit anderen Worten umfasst das strahlungsemittierende Bauelement bevorzugt mindestens drei strahlungsemittierende Halbleiterchips, von denen ein Halbleiterchip rotes Licht, ein Halbleiterchip grünes Licht und ein Halbleiterchip blaues Licht aussendet.

Das strahlungsemittierende Bauelement umfasst mindestens einen rot emittierenden Halbleiterchip und mindestens einen gelb emittierenden Halbleiterchip. Derartige Bauelemente sind insbesondere für Anwendungen im Automobilbereich geeignet, etwa in Blinker und/oder Rücklicht.

Das strahlungsemittierende Bauelement umfasst einen strahlungsemittierenden Halbleiterchip, der im Betrieb elektromagnetische Strahlung aus dem infraroten Spektralbereich aussendet. Besonders bevorzugt umfasst das strahlungsemittierende Bauelement bei dieser Ausführungsform außerdem zumindest einen rot emittierenden, zumindest einen grün emittierenden und zumindest einen blau emittierenden Halbleiterchip.

Ein solches strahlungsemittierendes Bauelement ist insbesondere zum Einsatz in einem Display oder einer Videowand zur Bildung eines oder mehrerer Bildpunkte geeignet. Im Betrieb des Displays oder der Videowand sendet der infrarote Halbleiterchip elektromagnetische Strahlung aus dem infraroten Spektralbereich aus, die beispielsweise Informationen, wie etwa QR-Kodes oder andere 2D-Kodes bereitstellt. Diese Informationen sind beispielsweise dazu vorgesehen, von einer Kamera außerhalb des Displays oder der Videowand erkannt zu werden.

Weiterhin können die Informationen auch einem Datenaustauschprotokoll entsprechend, so dass diese von einem Datenempfänger, wie einem Smartphone, empfangen und ausgelesen werden können. Besonders bevorzugt umfasst das strahlungsemittierende Bauelement bei dieser Ausführungsform einen Sensor, der dazu geeignet ist, infrarote Strahlung zu empfangen. Auf diese Art und Weise ist es möglich, dass auch das Display oder die Videowand Informationen von außerhalb empfangen. Ein derartiges Display oder eine derartige Videowand kann so beispielsweise mit Smartphones von Passanten Informationen austauschen, etwa zu Werbezwecken. Vorliegend wird mit dem Begriff "Videowand" insbesondere eine Bildanzeigevorrichtung mit Bildpunkten bezeichnet, bei der ein Abstand zwischen zwei direkt benachbarten Bildpunkten zumindest 500 Mikrometer beträgt. Außerdem ist die Videowand in der Regel modular aus mehreren Modulen aufgebaut. Die Videowand dient beispielsweise bei Großveranstaltungen zur Bildanzeige.

Mit dem Begriff "Display" wird vorliegend insbesondere eine Bildanzeigevorrichtung bezeichnet, bei der ein Abstand zwischen zwei direkt benachbarten Bildpunkten höchstens 500 Mikrometer beträgt. Das Display findet insbesondere in Fernsehern, Computermonitoren, intelligenten Uhren und/oder intelligenten mobilen Telefonen zur Bildanzeige Anwendung.

Auf jeder Durchkontaktierung des strahlungsemittierenden Bauelements ist eine elektrische Anschlussstelle aufgebracht, die mit dem Halbleiterchip elektrisch leitend verbunden ist. Hierbei überdeckt der Halbleiterchip die elektrische Anschlussstelle jeweils bevorzugt, besonders bevorzugt vollständig.

Der Verbindungsträger des strahlungsemittierenden Bauelements weist in Draufsicht eine sechseckige Form oder eine rechteckige Form auf. Besonders bevorzugt handelt es sich bei der sechseckigen Form um ein reguläres Sechseck.

Das strahlungsemittierende Bauelement weist eine Vielzahl an Halbleiterchips auf. Die Halbleiterchips und der Verbindungsträger weisen hierbei in Draufsicht eine rechteckige Form auf. Die Halbleiterchips sind bei dieser Ausführungsform besonders bevorzugt in Zeilen und/oder Spalten angeordnet.

Der Verbindungsträger weist in Draufsicht eine sechseckige Form auf. Außerdem umfasst das strahlungsemittierende Bauelement bevorzugt eine Vielzahl an Halbleiterchips, die mit jeweils einer Seitenfläche parallel zu einer Seitenfläche des Verbindungsträgers angeordnet sind. Bei dieser Ausführungsform können die Halbleiterchips eine in Draufsicht rechteckige oder dreieckige Form aufweisen.

Das strahlungsemittierende Bauelement umfasst mindestens einen elektronischen Halbleiterchip. Bei dem elektronischen Halbleiterchip kann es sich bei dem elektronischen Halbleiterchip um einen Sensor handeln. Beispielsweise detektiert der Sensor im Betrieb infrarote Strahlung, eine Temperatur wie eine Umgebungstemperatur oder eine Helligkeit, etwa der Umgebung. Weiterhin kann es sich bei dem elektronischen Halbleiterchip um einen Sensor handeln, der zu Bildaufnahme geeignet ist, wie einen CCD-Sensor oder einen CMOS-Sensor.

Das strahlungsemittierende Bauelement weist einen Sensor auf, der im Betrieb die Temperatur detektiert. Bevorzugt detektiert der Sensor die Temperatur des Bauelements. Ist die Temperatur des strahlungsemittierenden Bauelements bekannt, so eröffnet sich die Möglichkeit, eine Farbortverschiebung der Farbe der elektromagnetischen Strahlung der strahlungsemittierenden Halbleiterchips aufgrund von Temperaturunterschieden zu kompensieren.

Dabei umfasst das strahlungsemittierende Bauelement bevorzugt einen elektronischen Steuerchip, der zur Ansteuerung zumindest einem der Halbleiterchips des strahlungsemittierenden Bauelements dient. Beispielsweise umfasst der Steuerchip einen integrierten Schaltkreis. Bevorzugt ist der Steuerchip dazu eingerichtet, zumindest einen und bevorzugt alle strahlungsemittierenden Halbleiterchips mittels pulsweitenmodulierten Signalen anzusteuern. Pulsweitenmodulierte Signale sind in der Regel dazu geeignet, den Farbort des von den strahlungsemittierenden Halbleiterchips ausgesandten Lichts dynamisch an einen vorgegebenen Wert anzupassen. Bei dieser Ausführungsform ist es insbesondere mit Vorteil möglich, einen weiteren elektronischen Hochleistungschip in das Bauelement zu integrieren oder den Ansteuerchip mit zusätzlicher Hochleistungselektronik zu versehen ohne aufgrund der im Betrieb erzeugten hohen Temperaturen die Farbe des Lichts der strahlungsemittierenden Halbleiterchips zu verändern.

Das hier beschriebene strahlungsemittierende Bauelement ist insbesondere zur Verwendung in einer Videowand oder in einem Display geeignet. Insbesondere ein strahlungsemittierendes Bauelement mit einem rot emittierenden, einem grün emittierenden und einem blau emittierenden Halbleiterchip kann mit Vorteil als besonders kompakte RGB-Lichtquellen in der Videowand oder dem Display Anwendung finden. Die RGB-Lichtquelle kann beispielsweise Teil mindestens eines Bildpunkts der Videowand oder des Displays sein. Außerdem weist der vorliegend beschriebene Verbindungsträger eine lichtdurchlässige Matrix auf, die einen besonders großen Volumenanteil des Verbindungsträgers ausbildet.

Das strahlungsemittierende Bauelement weist einen Sensor auf, der im Betrieb die Helligkeit der Umgebung detektiert. Besonders bevorzugt umfasst das strahlungsemittierende Bauelement bei dieser Ausführungsform außerdem zumindest einen im Betrieb rot emittierenden, zumindest einen im Betrieb grün emittierenden und zumindest einen im Betrieb blau emittierenden Halbleiterchip. Ein solches strahlungsemittierendes Bauelement ist insbesondere zum Einsatz in einem Display oder einer Videowand zur Bildung eines oder mehrerer Bildpunkte geeignet. Mit Hilfe des Sensors, der die Helligkeit der Umgebung im Betrieb detektiert, ist es mit Vorteil möglich, die Helligkeit der Strahlung der strahlungsemittierenden Halbleiterchips so lokal und dynamisch anzupassen, dass an jeder Stelle ein erkennbares Bild des Displays oder der Videowand vorhanden ist, auch wenn unterschiedliche Umgebungshelligkeiten in verschiedenen Bereichen des Displays oder die Videowand vorhanden sind.

Das Bauelement umfasst weiterhin ein VCSEL. Besonders bevorzugt umfasst das strahlungsemittierende Bauelement bei dieser Ausführungsform außerdem zumindest einen im Betrieb rot emittierenden, zumindest einen im Betrieb grün emittierenden und zumindest einen im Betrieb blau emittierenden Halbleiterchip. Ein solches strahlungsemittierendes Bauelement ist insbesondere zum Einsatz in einem Display oder einer Videowand geeignet, das darüber hinaus mit einer 3D-Erkennungsvorrichtung ausgestattet ist. Auf diese Art und Weise kann eine Information darüber erzeugt werden, ob sich Objekte, beispielsweise Besucher, vor dem Display oder der Videowand befinden.

Das Bauelement weist einen CCD-Sensor und/oder einen CMOS-Sensor auf. Der CCD-Sensor und/oder der CMOS-Sensor dienen bevorzugt zur Bildaufnahme. Besonders bevorzugt umfasst das strahlungsemittierende Bauelement bei dieser Ausführungsform außerdem zumindest einen im Betrieb rot emittierenden, zumindest einen im Betrieb grün emittierenden und zumindest einen im Betrieb blau emittierenden Halbleiterchip. Ein solches Bauelement ist insbesondere zum Einsatz in einem Display oder in einer Videowand mit einer gekrümmten Bildfläche zur Bildung eines oder mehrerer Bildpunkte geeignet. Beispielsweise weist die gekrümmte Bildfläche die Form eines Segments einer Kugelfläche auf. Insbesondere in Verbindung mit der gekrümmten Bildfläche des Displays oder der Videowand ist es durch die CCD-Sensoren und/oder CMOS-Sensoren möglich, ein Facettenauge als Kamera des Displays oder der Videowand auszubilden.

Das hier beschriebene strahlungsemittierende Bauelement ist insbesondere zur Verwendung einem Modul zur Bildanzeige geeignet. Beispielsweis ist das Modul Teil eines Displays oder einer Videowand. Merkmale und Ausführungsformen die vorliegend lediglich in Zusammenhang mit dem strahlungsemittierenden Bauelement beschrieben sind können auch bei dem Modul ausgebildet sein und umgekehrt.

Das Modul umfasst eine Vielzahl an strahlungsemittierenden Bauelementen. Die strahlungsemittierenden Bauelemente sind bevorzugt auf einer ersten Hauptfläche eines Substrats angeordnet und dazu eingerichtet, Bildpunkte zur Bildanzeige auszubilden.

Das Modul umfasst einen elektronischen Steuerchip auf einer zweiten Hauptfläche des Substrats, die der ersten Hauptfläche gegenüber liegt. Der Steuerchip dient bevorzugt zur Ansteuerung der strahlungsemittierenden Halbleiterchips zumindest eines Bauelements des Moduls. Bevorzugt ist der Steuerchip dazu eingerichtet, die strahlungsemittierenden Halbleiterchips aller Bauelemente anzusteuern Beispielsweise umfasst der Steuerchip einen integrierten Schaltkreis. Bevorzugt ist der Steuerchip dazu eingerichtet, zumindest einen und bevorzugt alle strahlungsemittierenden Halbleiterchips des Moduls mittels pulsweitenmodulierten Signalen anzusteuern. Pulsweitenmodulierte Signale sind in der Regel dazu geeignet, den Farbort des von den strahlungsemittierenden Halbleiterchips ausgesandten Lichts dynamisch an einen vorgegebenen Wert anzupassen. Bei dieser Ausführungsform ist es insbesondere mit Vorteil möglich, einen weiteren elektronischen Hochleistungschip in das Modul zu integrieren oder den Ansteuerchip mit zusätzlicher Hochleistungselektronik zu versehen ohne aufgrund der im Betrieb erzeugten hohen Temperaturen die Farbe des Lichts der strahlungsemittierenden Halbleiterchips zu verändern.

Vorteilhafte Ausführungen und Weiterbildungen der beiden Verfahren, des Konversionselements und des strahlungsemittierenden Bauelement werden im Folgenden anhand der Figuren näher erläutert.

Die Figuren 1 bis 6 zeigen schematische Schnittdarstellungen von Verfahrensstadien eines Verfahrens zur Herstellung einer Vielzahl räumlich voneinander getrennter Verbindungsträger gemäß einem Ausführungsbeispiel.

Figur 7 zeigt eine schematische Schnittdarstellung einer Vielzahl von Verbindungsträgern gemäß einem Beispiel.

Die Figuren 8 bis 9 zeigen schematische Schnittdarstellungen von Verfahrensstadien eines Verfahrens zur Herstellung eines strahlungsemittierenden Bauelements gemäß einem Ausführungsbeispiel.

Die Figuren 10 bis 13 zeigen schematische Draufsichten auf Verfahrensstadien eines Verfahrens zur Herstellung eines strahlungsemittierenden Bauelements gemäß einem weiteren Ausführungsbeispiel.

Die Figuren 14 bis 15 zeigen schematische Draufsichten auf Verfahrensstadien eines Verfahrens zur Herstellung strahlungsemittierender Bauelemente gemäß einem weiteren Ausführungsbeispiel.

Die Figuren 16 bis 22 zeigen schematische Draufsichten auf strahlungsemittierende Bauelemente gemäß verschiedener Beispiele.

Die Figur 23 zeigt eine schematische perspektivische Ansicht eines Moduls gemäß einem Beispiel.

Die Figur 24 zeigt exemplarisch eine Temperaturverteilung einer Bildfläche eines Moduls.

Die Figur 25 zeigt beispielhaft die Koordinaten Cx und Cy des Farbortes des von einem strahlungsemittierenden Halbleiterchips Lichts in Abhängigkeit der Temperatur T.

Die Figur 26 zeigt eine schematische Ansicht einer Videowand gemäß einem Beispiel.

Die Figur 27 zeigt eine schematische Ansicht eines Displays gemäß einem Beispiel.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente, insbesondere Schichtdicken, zur besseren Darstellbarkeit und/oder zum besseren Verständnis übertrieben groß dargestellt sein.

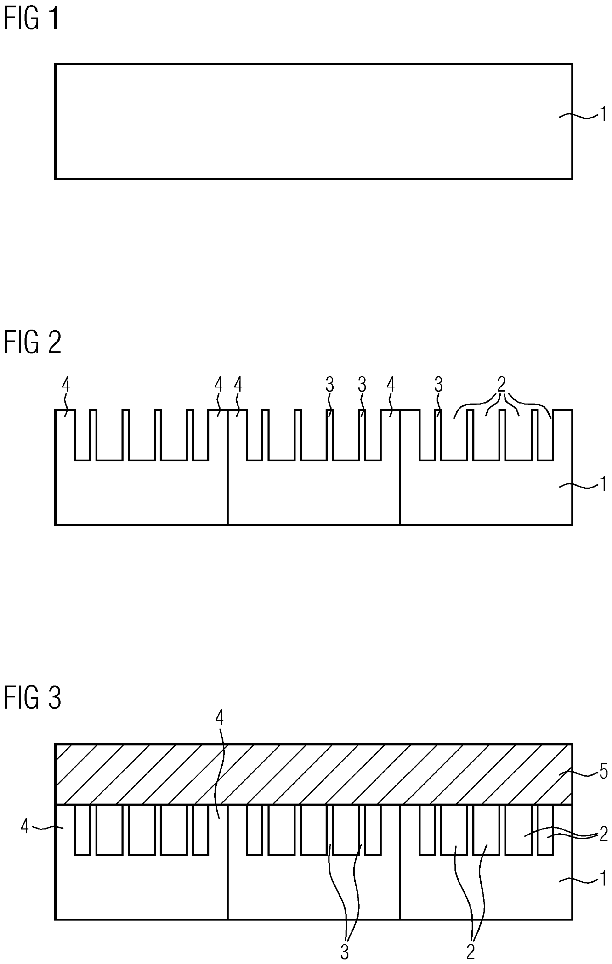

Bei dem Verfahren gemäß dem Ausführungsbeispiel der Figuren 1 bis 6 wird zunächst ein Halbleiterwafer 1 bereitgestellt (Figur 1). Der Halbleiterwafer 1 ist beispielsweise aus hochdotiertem Silizium gebildet.

Der Halbleiterwafer 1 wird ausgehend von einer ersten Hauptfläche mit Ausnehmungen 2 strukturiert, in denen Pfosten 3 angeordnet sind. Beispielsweise weisen die Ausnehmungen 2 eine Tiefe von ungefähr 200 Mikrometer auf. Außerdem weist der Halbleiterwafer 1 Rahmen 4 auf, von denen jeder jeweils eine Vielzahl an Pfosten 3 umläuft (Figur 2). Die Strukturierung des Halbleiterwafers 1 kann beispielsweise mit Hilfe einer lithografischen Maske und einem Ätzprozess erfolgen.

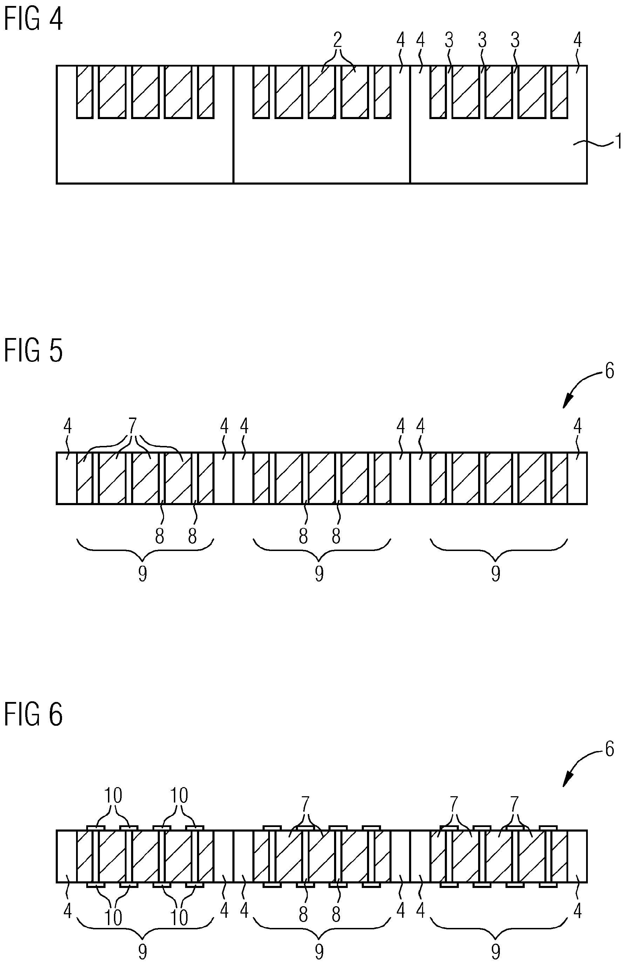

In einem nächsten Schritt, der schematisch in den Figuren 3 und 4 dargestellt ist, werden die Ausnehmungen 2 mit Glas gefüllt. Hierzu wird ein Glaswafer 5 auf die strukturierte erste Hauptfläche des Halbleiterwafers 1 unter Vakuum aufgebracht (Figur 3) und aufgeschmolzen, beispielsweise durch Heizen. Das flüssige Glas füllt die Ausnehmungen 2 aus, besonders bevorzugt vollständig (Figur 4).

In einem nächsten Schritt wird der Halbleiterwafer 1 von seiner zweiten Hauptseite, die der ersten Hauptseite gegenüberliegt, gedünnt (Figur 5). Durch das Dünnen wird das Material des Halbleiterwafers 1, das ausgehend von der zweiten Hauptseite des Halbleiterwafers 1 die Pfosten 3 miteinander verbindet und eine Bodenfläche der Ausnehmungen 2 ausbildet, entfernt. Nach dem Dünnen ist das Glas vorliegend frei zugänglich.

Durch das Dünnen entsteht ein Verbund 6 mit einer lichtdurchlässigen Matrix 7, die vorliegend aus Glas gebildet ist, und einer Vielzahl an Durchkontaktierungen 8, die aus dem Material des Halbleiterwafers 1 gebildet sind. Außerdem umfasst der Verbund 6 eine Vielzahl an Rahmen 4, die jeweils eine Vielzahl an Durchkontaktierungen 8 vollständig umläuft. Mit anderen Worten umfasst der Verbund 6 eine Vielzahl von Verbindungsträgern 9, die durch umlaufende Rahmen 4 voneinander beabstandet sind. Die Rahmen 4 weisen hierbei das gleiche Material wie die Durchkontaktierungen 8 auf, nämlich hochdotiertes Silizium. Nach dem Dünnen weist der Verbund 6 vorliegend eine Dicke von ungefähr 100 Mikrometer auf.

In einem nächsten Schritt wird auf jeder Durchkontaktierung 8 eine elektrische Anschlussstelle 10 angeordnet (Figur 6). Die elektrischen Anschlussstellen 10 sind hierbei beabstandet voneinander positioniert. Jede elektrische Anschlussstelle 10 überdeckt eine Durchkontaktierung 8 vorliegend vollständig. Die elektrischen Anschlussstellen 10 sind besonders bevorzugt metallisch ausgebildet. Beispielsweise bestehen die elektrischen Anschlussstellen 10 aus Gold. Die elektrischen Anschlussstellen 10 können zumindest teilweise auch vor dem Dünnen aufgebracht werden.

In einem nächsten Schritt werden die Verbindungsträger 9 vereinzelt, in dem die Rahmen 4 aus dem Verbund 6 vollständig oder teilweise entfernt werden, beispielsweise durch anisotropes Ätzen in einem Plasma, isotropes Ätzen in einem Gas oder einer Flüssigkeit. Die Durchkontaktierungen 8 werden hierbei durch die elektrischen Anschlussstellen 10 vor dem Plasma geschützt, so dass mit Vorteil auf eine Maske verzichtet werden kann.

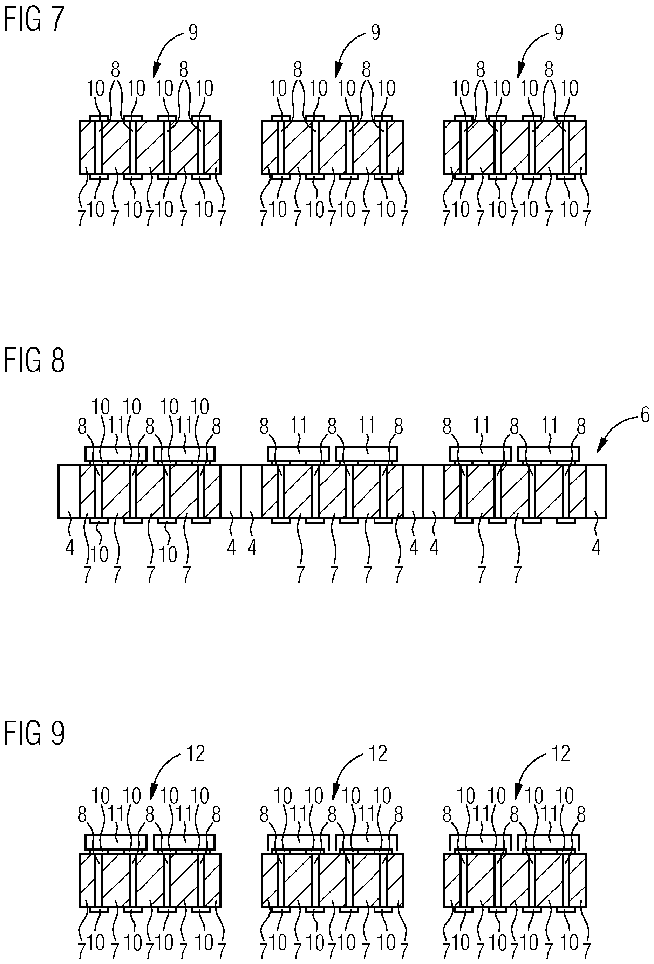

Figur 7 zeigt eine Vielzahl räumlich voneinander getrennter fertiger Verbindungsträger 9, die mit dem anhand der Figuren 1 bis 6 beschriebenen Verfahren hergestellt werden können.

Die Verbindungsträger 9 gemäß dem Beispiel der Figur 7 weisen eine lichtdurchlässige Matrix 7 auf, die vorliegend aus Glas gebildet ist. Innerhalb der lichtdurchlässigen Matrix 7 ist eine Vielzahl an Durchkontaktierungen 8 angeordnet, die vorliegend ein hochdotiertes Silizium aufweisen. Die Durchkontaktierungen 8 erstrecken sich von einer ersten Hauptfläche des Verbindungsträgers 9 zu einer zweiten Hauptfläche des Verbindungsträgers 9. Die Durchkontaktierungen 8 können hierbei an den beiden Hauptflächen jeweils bündig mit der Matrix 7 abschließen. Weiterhin ist es auch möglich, dass die Durchkontaktierungen 8 gegenüber der Matrix 7 an zumindest einer Hauptfläche zurückgesetzt sind (vorliegend nicht dargestellt). Die Durchkontaktierungen 8 sind voneinander durch die Matrix 7 elektrisch isoliert.

Auf den Durchkontaktierungen 8 sind elektrische Anschlussstellen 10, beispielsweise aus Gold, angeordnet. Die elektrischen Anschlussstellen 10 überdecken hierbei die Durchkontaktierungen 8 vollständig. Seitenflächen der Verbindungsträger 9, die zwischen deren ersten Hauptfläche und der zweiten Hauptfläche angeordnet sind, sind vorliegend vollständig aus der lichtdurchlässigen Matrix 7 gebildet. Die Verbindungsträger 9 weisen beispielsweise eine Fläche von ungefähr 140 Mikrometer mal 210 Mikrometer auf.

Bei dem Verfahren des Ausführungsbeispiels gemäß den Figuren 8 und 9 wird zunächst ein Verbund 6 erzeugt, wie anhand der Figuren 1 bis 6 bereits beschrieben.

Auf die elektrischen Anschlussstellen 10 des Verbunds 6 werden strahlungsemittierende Halbleiterchips 11 aufgebracht (Figur 8). Hierbei werden die strahlungsemittierenden Halbleiterchips 11 mit den elektrischen Anschlussstellen 10 der ersten Hauptfläche des Verbunds 6 elektrisch leitend verbunden, sodass sie über die elektrischen Anschlussstellen 10 auf der zweiten Hauptfläche des Verbunds 6 später extern elektrisch kontaktiert werden können. Die strahlungsemittierenden Halbleiterchips 11 können auch vor dem Dünnen auf den Verbund 6 aufgebracht werden.

In einem nächsten Schritt werden die strahlungsemittierenden Bauelemente 12 vereinzelt, in dem die Rahmen 4 vollständig oder teilweise entfernt werden, beispielsweise durch isotropes Ätzen in einem Gas (Figur 9).

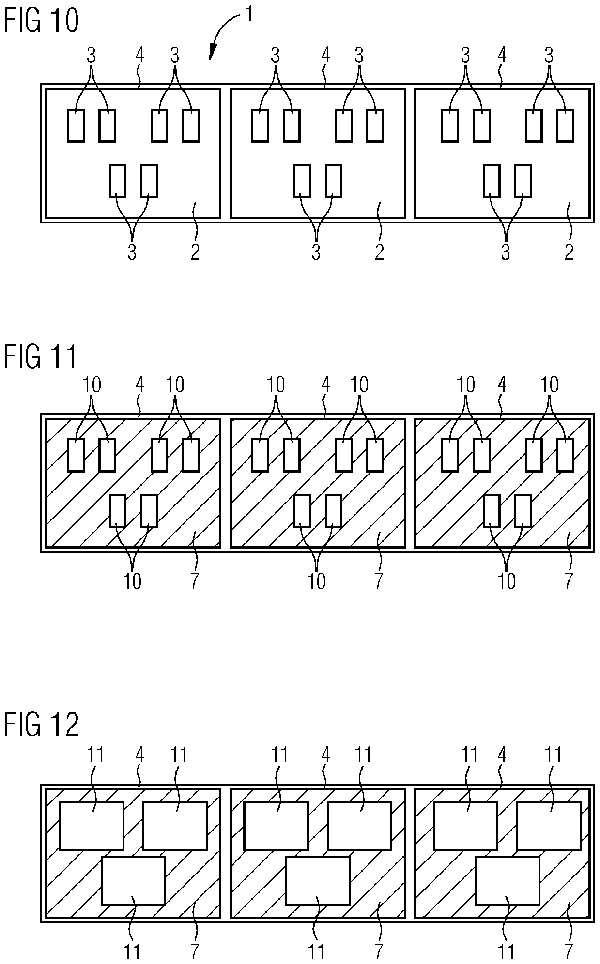

Bei dem Verfahren gemäß dem Ausführungsbeispiel der Figuren 10 bis 13 wird wiederum ein strukturierter Halbleiterwafer 1 bereitgestellt. Dieser weist eine Vielzahl an Rahmen 4 auf, von denen jeder eine Vielzahl an Pfosten 3 umläuft, die in Ausnehmungen 2 angeordnet sind (Figur 10).

In einem nächsten Schritt wird in die Ausnehmungen 2 zwischen den Pfosten 3 innerhalb jedes Rahmens 4 eine lichtdurchlässige Matrix 7, vorliegend Glas, gefüllt. Auf die Durchkontaktierungen 8 werden elektrische Anschlussstellen 10 aufgebracht (Figur 11).

Dann wird auf jeweils zwei elektrische Anschlussstellen 10 ein strahlungsemittierender Halbleiterchip 11 aufgebracht, wie in Figur 12 dargestellt. Die Halbleiterchips 11 werden hierbei elektrisch leitend mit den elektrischen Anschlussstellen 10 verbunden.

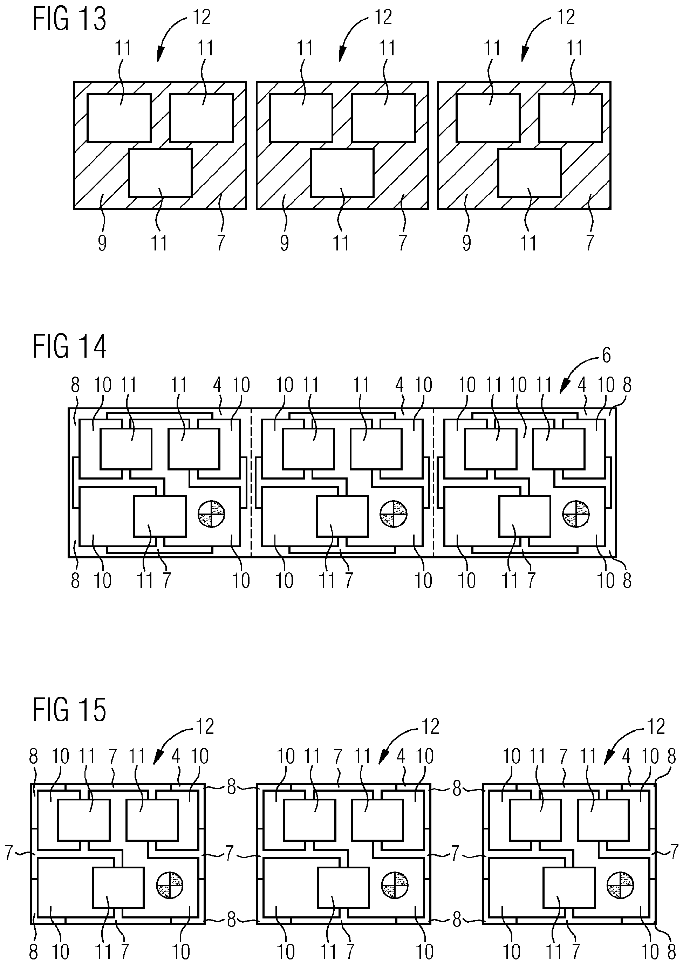

In einem nächsten Schritt werden die Rahmen 4 vollständig oder teilweise entfernt, sodass die strahlungsemittierenden Bauelemente 12 vereinzelt werden (Figur 13). Das Entfernen der Rahmen 4 erfolgt beispielsweise durch isotropes Ätzen. Die strahlungsemittierenden Bauelemente 12 weisen beispielsweise eine Fläche von ungefähr 140 Mikrometer mal 175 Mikrometer auf.

Bei dem Verfahren gemäß dem Ausführungsbeispiel der Figuren 14 und 15 wird wiederum ein Verbund 6 mit einer Vielzahl an Verbindungsträgern 9 bereitgestellt (Figur 14). Jeder Verbindungsträger 9 weist hierbei eine Vielzahl an Durchkontaktierungen 8 auf, die vorliegend vollständig von elektrischen Anschlussstellen 10 überdeckt sind. Auf den elektrischen Anschlussstellen 10 sind strahlungsemittierende Halbleiterchips 11 aufgebracht. Die elektrischen Anschlussstellen 10 sind hierbei durch eine lichtdurchlässige Matrix 7 elektrisch voneinander isoliert. Die lichtdurchlässige Matrix 7 ist vorliegend aus Glas gebildet. Außerdem ist jeder Verbindungsträger 9 von einem Rahmen 4 umgeben. Jeweils zwei Rahmen 4, die direkt benachbarte Verbindungsträger umlaufen, sind hierbei direkt zusammenhängend ausgebildet. Außerdem ist jeder Rahmen 4 mit Durchkontaktierungen 8 des Verbindungsträgers 9, den der Rahmen 4 umläuft, zusammenhängend ausgebildet. Zumindest einige Durchkontaktierungen 8 innerhalb eines Rahmens 4 sind bei diesem Verfahrensstadium einstückig mit dem Rahmen 4 ausgebildet.

Die strahlungsemittierenden Bauelemente 12 werden in einem nächsten Schritt vereinzelt, vorliegend durch anisotropes Ätzen, beispielsweise mit einem Bosch-Prozess (Figur 15). Bei der Vereinzelung werden die Rahmen 4 durch anisotropes Ätzen, beispielsweise mittels eines Bosch-Prozesses, vollständig oder teilweise entfernt. Hierbei bleiben die Durchkontaktierungen 8 erhalten und bilden jeweils einen Teil der Seitenfläche der vereinzelten Verbindungsträger 9 aus. Die Bauelemente 12 weisen vorliegend beispielsweise eine Fläche von ungefähr 160 Mikrometer mal 205 Mikrometer auf.

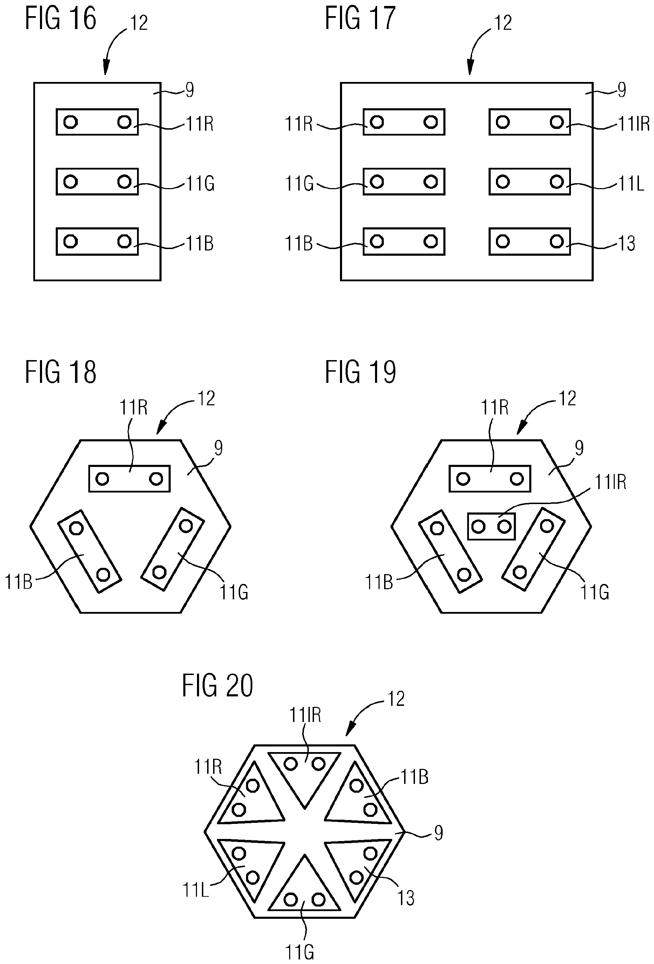

Das strahlungsemittierende Bauelement 12 gemäß dem Beispiel der Figur 16 umfasst einen Verbindungsträger 9, der in Draufsicht eine rechteckige Form aufweist. Außerdem weist das strahlungsemittierende Bauelement 12 gemäß dem Beispiel der Figur 16 drei strahlungsemittierende Halbleiterchips 11R, 11G, 11B auf, von denen ein Halbleiterchip rotes Licht, ein Halbleiterchip grünes Licht und ein Halbleiterchip im Betrieb blaues Licht aussendet. Die strahlungsemittierenden Halbleiterchips 11R 11G, 11B weisen vorliegend wie der Verbindungsträger 9 eine in Draufsicht rechteckige Form auf. Die Halbleiterchips 11R, 11G, 11B sind vorliegend in einer Spalte angeordnet.

Das strahlungsemittierende Bauelement 12 gemäß dem Beispiel der Figur 17 weist im Unterschied zu dem strahlungsemittierenden Bauelement 12 gemäß der Figur 16 zusätzlich zu dem rot emittierenden Halbleiterchip 11R, dem grün emittierenden Halbleiterchip 11G und dem blau emittierenden Halbleiterchip 11B einen infrarot emittierenden Halbleiterchip 11IR, ein VCSEL 11L sowie einen Sensor 13 auf. Beispielsweise ist der Sensor 13 dazu ausgebildet, infrarote Strahlung zu detektieren. Mittels des infrarot emittierenden Halbleiterchips 11IR kann beispielsweise Information bereitgestellt werden, die nicht im sichtbaren Bereich liegt. Die strahlungsemittierenden Halbleiterchips 11R, 11G, 11B, die Licht aus dem sichtbaren Bereich aussenden, sind bei diesem Beispiel in einer gemeinsamen Spalte angeordnet. In einer direkt benachbarten Spalte sind der infrarot emittierende Halbleiterchip 11IR, das VCSEL 11L sowie der Sensor 13 angeordnet.

Das Bauelement 12 gemäß dem Beispiel der Figur 18 umfasst im Unterschied zu dem strahlungsemittierenden Bauelement 12 der Figur 16 einen Verbindungsträger 9, der in Draufsicht eine sechseckige Form aufweist. Der rot emittierende Halbleiterchip 11R, der grün emittierende Halbleiterchip 11G und der blau emittierende Halbleiterchip 11B weisen bei diesem Beispiel eine rechteckige Form auf. Die strahlungsemittierenden Halbleiterchips 11R, 11G, 11B sind jeweils mit einer Seitenfläche parallel zu einer Seitenfläche des Verbindungsträgers 9 angeordnet.

Das strahlungsemittierende Bauelement 12 gemäß dem Beispiel der Figur 19 weist im Unterschied zu dem strahlungsemittierenden Bauelement 12 gemäß der Figur 18 einen weiteren Halbleiterchip 11IR auf, der im Betrieb infrarote Strahlung aussendet. Der Halbleiterchip 11IR, der infrarote Strahlung aussendet, ist mittig auf dem Verbindungsträger 9 positioniert.

Das strahlungsemittierende Bauelement 12 gemäß dem Beispiel der Figur 20 weist wie die strahlungsemittierenden Bauelemente 12 gemäß den Beispielen der Figuren 18 und 19 einen Verbindungsträger 9 mit einer sechseckigen Form in Draufsicht auf. Im Unterschied zu den Beispielen der Figuren 18 und 19 weisen die Halbleiterchips 11R, 11G, 11B, 11L, 11IR 13 des Bauelements 12 gemäß dem Beispiel der Figur 20 jedoch eine dreieckige Form auf. Die Halbleiterchips 11R, 11G, 11B, 11L, 11IR sind hierbei jeweils mit einer Seitenfläche parallel zu einer Seitenfläche des Verbindungsträgers 9 angeordnet. Die Verwendung von Halbleiterchips 11R, 11G, 11B, 11L, 11IR, 13 mit einer in Draufsicht dreieckigen Form und einem Verbindungsträger 9 mit einer in Draufsicht sechseckigen Form erlaubt eine besonders gute Flächenausnutzung des Verbindungsträgers 9.

Das strahlungsemittierende Bauelement gemäß der Figur 20 weist einen rot emittierenden Halbleiterchip 11R, einen blau emittierenden Halbleiterchip 11B und einen grün emittierenden Halbleiterchip 11G auf. Zwischen jeweils zwei Halbleiterchips 11R, 11G, 11B, die sichtbares Licht emittieren, sind vorliegend ein infrarot emittierender Halbleiterchip 11IR, ein Sensor 13 oder ein VCSEL 11L angeordnet.

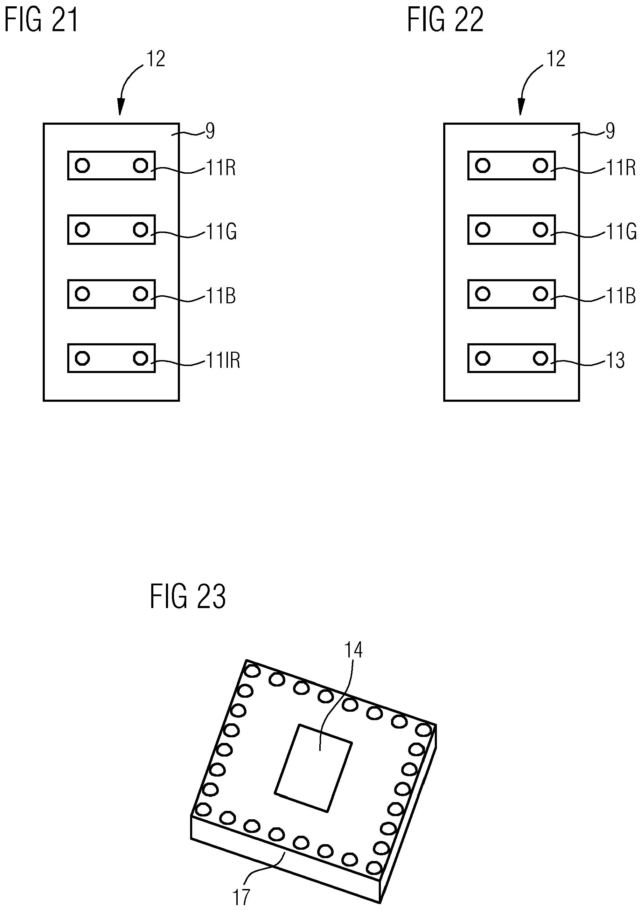

Das Bauelement 12 gemäß dem Beispiel der Figur 21 weist im Unterschied zu dem strahlungsemittierenden Bauelement 12 gemäß der Figur 16 zusätzlich zu einem im Betrieb rot emittierenden Halbleiterchip 11R, einem im Betrieb grün emittierenden Halbleiterchip 11B und einem im Betrieb blau emittierenden Halbleiterchip 11B einen strahlungsemittierenden Halbleiterchip 11IR auf, der im Betrieb infrarote Strahlung aussendet. Die strahlungsemittierenden Halbleiterchips 11R, 11G, 11B, 11IR sind in einer Reihe angeordnet.

Das strahlungsemittierende Bauelement 12 gemäß dem Beispiel der Figur 21 weist ein anderes Design auf als das strahlungsemittierende Bauelement 12 gemäß der Figur 19, während die strahlungsemittierenden Halbleiterchips 11R, 11G, 11B, 11IR gleichartig ausgebildet sind. Durch den strahlungsemittierenden Halbleiterchip 11IR, der infrarote elektromagnetische Strahlung aussendet, können mit Vorteil Informationen bereitgestellt werden, die für das menschliche Auge nicht sichtbar sind.

Das Bauelement 12 gemäß dem Beispiel der Figur 22 weist im Unterschied zu dem Bauelement 12 gemäß der Figur 21 statt des strahlungsemittierenden Halbleiterchips 11IR, der infrarote Strahlung aussendet, einen Sensor 13 auf, der im Betrieb die Helligkeit der Umgebung detektiert.

Das Modul gemäß dem Beispiel der Figur 23 weist eine Vielzahl an strahlungsemittierenden Bauelementen 12 auf, die auf eine erste Hauptfläche eines Substrats 17 aufgebracht sind. Die strahlungsemittierenden Bauelemente 12 sind vorliegend nicht sichtbar.

Bevorzugt umfasst das strahlungsemittierende Bauelement 12 drei strahlungsemittierenden Halbleiterchips 11R, 11G, 11B, von denen einer im Betrieb rotes Licht, einer im Betrieb grünes Licht und einer im Betrieb blaues Licht aussendet. Auf einer zweiten Hauptfläche des Substrats 17 ist mittig ein elektronischer Steuerchip 14 angeordnet. Weiterhin weisen die strahlungsemittierenden Bauelemente des Moduls gemäß dem Beispiel der Figur 23 jeweils einen Sensor 13 (nicht dargestellt) auf, der die Temperatur der Halbleiterchips 11R, 11G, 11B detektiert.

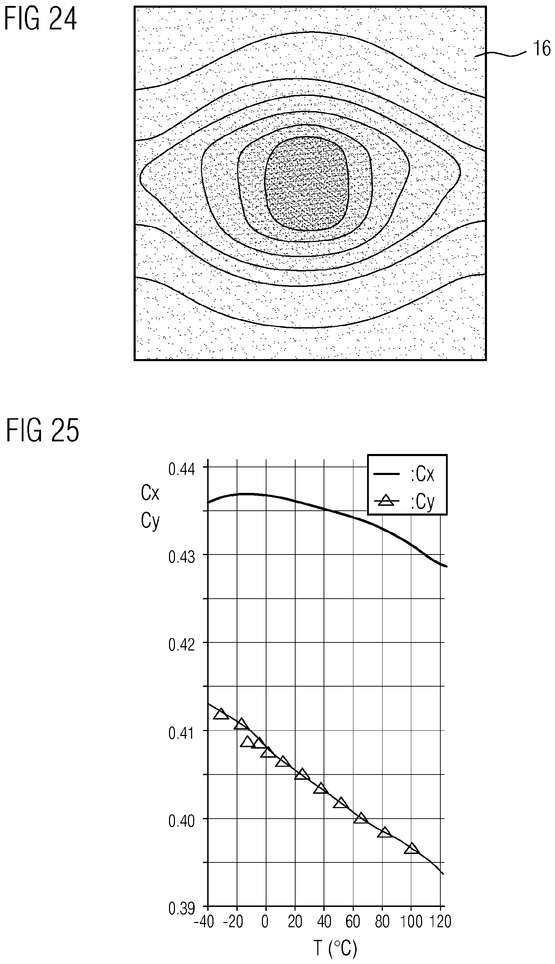

Bei einer Erhöhung der Temperatur der strahlungsemittierenden Halbleiterchips 11R, 11G, 11B werden die Farborte der von den Halbleiterchips 11R, 11G, 11B ausgesandten elektromagnetischen Strahlung mit steigender Temperatur in der Regel zu niedrigeren Werten verschoben. Eine derartige Verschiebung ist beispielsweise in Figur 25 gezeigt. Dadurch entsteht eine ungleichmäßige Temperaturverteilung über eine Bildfläche 16 des Moduls wie in Figur 24 gezeigt.

Bei dem Modul gemäß dem Beispiel der Figur 23 wird die Temperatur T durch den Temperatursensor gemessen und der gemessene Wert an den elektronischen Steuerchip 14 auf der Rückseite des Moduls weitergeleitet. Der elektronische Steuerchip 14 ist dazu eingerichtet, die strahlungsemittierenden Halbleiterchips 11R, 11G, 11B mit pulsweitenmodulierten Signale im Betrieb des Moduls anzusteuern, so dass die Farborte des von den strahlungsemittierenden Halbleiterchips 11R, 11G, 11B ausgesandten Lichts bei einer Änderung der Temperatur der strahlungsemittierenden Halbleiterchips 11R, 11G, 11B auf ein gewünschten Wert eingestellt werden.

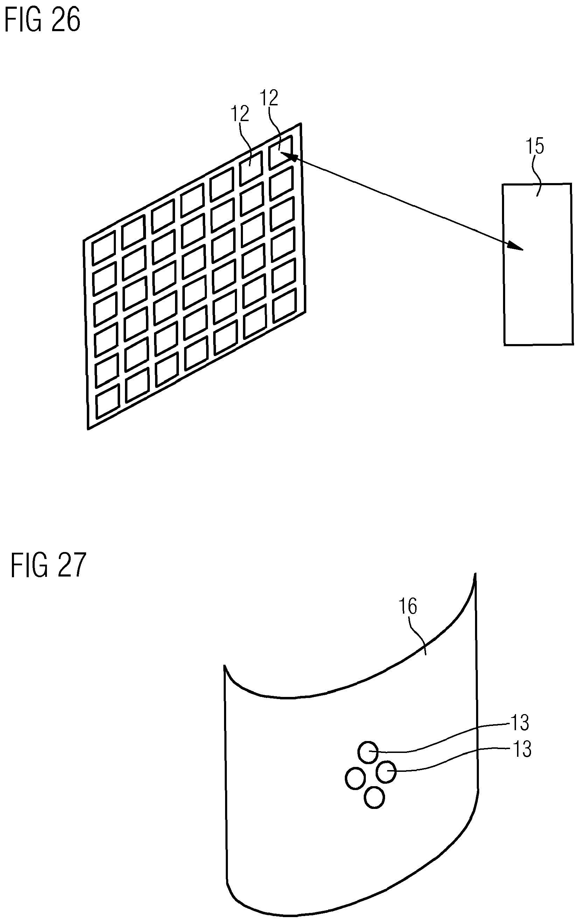

Die Videowand gemäß dem Beispiel der Figur 26 weist eine Vielzahl von strahlungsemittierenden Bauelementen 12 auf, wie sie beispielsweise anhand der Figur 16 bereits beschrieben wurde. Weiterhin weist die Videowand gemäß dem Beispiel der Figur 26 zumindest ein strahlungsemittierendes Bauelement 12 auf, wie es bereits anhand der Figur 21 beschrieben wurde. Mit anderen Worten weist die Videowand zumindest ein strahlungsemittierendes Bauelement 12 mit einem Halbleiterchip 11IR auf, der im Betrieb infrarote Strahlung aussendet. Die im Betrieb rot emittierenden, im Betrieb grün emittierenden und im Betrieb blau emittierenden Halbleiterchips 11R, 11G, 11B der Bauelemente 12 bilden vorliegenden Bildpunkte der Videowand aus.

Die infrarote Strahlung kann beispielsweise von einem mobilen Endgerät 15, wie etwa einem intelligenten tragbaren Telefon, empfangen werden, so dass es möglich ist, von der Videowand geeignete Informationen auf das mobile Endgerät 15 zu senden. Hierzu gehorcht die infrarote Strahlung in der Regel einem IR-Protokoll.

Weiterhin ist es möglich, dass die Videowand gemäß dem Beispiel der Figur 26 alternativ oder zusätzlich ein strahlungsemittierendes Bauelement 12 aufweist, wie es bereits anhand der Figur 17 beschrieben wurde. Ein derartiges Bauelement 12 weist insbesondere ein VCSEL 11L auf, das es zusammen mit einer 3D-Erkennung ermöglicht, zu detektieren ob sich Zuschauer vor der Videowand befinden.

Außerdem weist das Bauelement 12 gemäß der Figur 17 einen infrarote Strahlung emittierenden Halbleiterchip 11IR und einen Sensor 13 auf, der infrarote Strahlung detektieren kann. Dies ermöglicht eine Kommunikation der Videowand mit einem mobilen Endgerät 15 durch infrarote Strahlung.

Das Display gemäß dem Beispiel der Figur 27 weist eine gekrümmte Bildfläche 16 auf. Das Display weist eine Vielzahl strahlungsemittierender Bauelemente 12 auf, von denen lediglich die Bauelemente 12 in einem Zentrum der Bildfläche 16 neben einem rot emittierenden Halbleiterchip 11R, einem grün emittierenden Halbleiterchip 11G und einem blau emittierenden Halbleiterchip 11B zur Ausbildung von Bildpunkten, einen Sensor 13 aufweisen, der zur Bildaufnahme geeignet ist, wie einen CCD-Sensor oder einen CMOS-Sensor. Die strahlungsemittierenden Halbleiterchips 11R, 11G, 11B sind in Figur 27 aus Gründen der Übersichtlichkeit nicht dargestellt, sondern lediglich die Sensoren 13, die im Zentrum der Bildfläche ein Facettenauge ausbilden.

Die vorliegende Anmeldung beansprucht die Priorität der deutschen Anmeldung DE 102018128570.1, deren Offenbarungsgehalt hiermit durch Rückbezug aufgenommen wird. Die Erfindung ist nicht durch die Beschreibung anhand der Ausführungsbeispiele auf diese beschränkt. Vielmehr ist die Erfindung durch die angehängten Patentansprüche definiert.

### Bezugszeichenliste

- 1: Halbleiterwafer
- 2: Ausnehmung
- 3: Pfosten
- 4: Rahmen
- 5: Glaswafer
- 6: Verbund
- 7: lichtdurchlässige Matrix
- 8: Durchkontaktierung
- 9: Verbindungsträger
- 10: elektrische Anschlussstelle
- 11, 11R, 11G, 11B, 11IR, 11L: strahlungsemittierender Halbleiterchip
- 12: strahlungsemittierendes Bauelement
- 13: Sensor
- 14: elektronischer Steuerchip
- 15: mobiles Endgerät
- 16: Bildfläche
- 17: Substrat

## Patentansprüche

1. Verfahren zur Herstellung einer Vielzahl strahlungsemittierender Bauelemente (12) mit den folgenden Schritten:
- Bereitstellen eines Verbunds (6) mit einer Vielzahl an Verbindungsträgern (9), wobei
- jeder Verbindungsträger (9) eine lichtdurchlässige Matrix (7) aufweist, in der Durchkontaktierungen (8) angeordnet sind, die sich von einer ersten Hauptfläche des Verbindungsträgers (9) zu einer zweiten Hauptfläche des Verbindungsträgers (9) hindurch erstrecken, und
- die Verbindungsträger (9) durch Rahmen (4) voneinander beabstandet sind, die jeden Verbindungsträger (9) umlaufen,
- Anordnen eines strahlungsemittierenden Halbleiterchips (11) auf zwei Durchkontaktierungen (8), und
- Vereinzeln der Bauelemente (12) durch vollständiges oder teilweises Entfernen der Rahmen (4).

2. Verfahren nach dem vorherigen Anspruch,
bei dem das Bereitstellen des Verbunds (6) die folgenden Schritte umfasst:
- Bereitstellen eines Halbleiterwafers (1),
- Strukturierung des Halbleiterwafers (1) mit Ausnehmungen (2) ausgehend von einer ersten Hauptfläche, wobei in den Ausnehmungen (2) Pfosten (3) angeordnet sind, und
- Füllen der Ausnehmungen (2) mit Glas durch Aufschmelzen eines Glaswafers (5), so dass der Verbund (6) entsteht.

3. Verfahren nach dem vorherigen Anspruch,
bei dem der Verbund (6) gedünnt wird, so dass die Vielzahl an Verbindungsträgern (9) entsteht.

4. Verfahren nach dem vorherigen Anspruch,
bei dem auf den Durchkontaktierungen (8) elektrische Anschlussstellen (10) angeordnet werden.

5. Verfahren nach einem der obigen Ansprüche,
bei dem die Rahmen (4) durch Ätzen vollständig oder teilweise entfernt werden.

6. Verfahren nach einem der obigen Ansprüche, bei dem
- vor dem Ätzen auf den Durchkontaktierungen (8) elektrische Anschlussstellen (10) angeordnet sind,
- die Rahmen (4) durch isotropes Ätzen mit Hilfe eines Gases oder einer Flüssigkeit vollständig oder teilweise entfernt werden, wobei keine zusätzliche lithographische Maske verwendet wird, und
- Seitenflächen der Verbindungsträger (9) vollständig aus der Matrix (7) gebildet sind.

7. Verfahren nach einem der Ansprüche 1 bis 5, bei dem
- die Rahmen (4) durch anisotropes Ätzen unter Verwendung einer Maske vollständig oder teilweise entfernt werden, und
- die Durchkontaktierungen (8) teilweise die Seitenflächen der Verbindungsträger (9) ausbilden.

8. Verfahren zur Herstellung einer Vielzahl räumlich voneinander getrennter Verbindungsträger (9) mit den folgenden Schritten:
- Bereitstellen eines Verbunds (6) mit einer Vielzahl an Verbindungsträgern (9), wobei
- jeder Verbindungsträger (9) eine lichtdurchlässige Matrix (7) aufweist, in der Durchkontaktierungen (8) angeordnet sind, die sich von einer ersten Hauptfläche des Verbindungsträgers (9) zu einer zweiten Hauptfläche des Verbindungsträgers (9) hindurch erstrecken, und
- die Verbindungsträger (9) durch Rahmen (4) voneinander beabstandet sind, die jeden Verbindungsträger (9) vollständig umlaufen,
- Vereinzeln der Verbindungsträger (9) durch vollständiges oder teilweises Entfernen der Rahmen (4).

9. Verfahren nach einem der obigen Ansprüche, bei dem das strahlungsemittierende Bauelement (12) mindestens einen rot emittierenden Halbleiterchip (11R), mindestens einen grün emittierenden Halbleiterchip (11G) und mindestens einen blau emittierenden Halbleiterchip (11B) auf dem Verbindungsträger (9) aufweist.

10. Verfahren nach einem der obigen Ansprüche,
bei dem auf jeder Durchkontaktierung (8) eine elektrische Anschlussstelle (10) aufgebracht wird, die mit dem Halbleiterchip (11, 13) elektrisch leitend verbunden wird, wobei der Halbleiterchip (11, 13) die elektrischen Anschlussstellen (10) überdeckt.

11. Verfahren nach einem der obigen Ansprüche,
bei dem der Verbindungsträger (9) in Draufsicht eine sechseckige Form oder rechteckige Form aufweist.

12. Verfahren nach einem der obigen Ansprüche, bei dem
- das strahlungsemittierende Bauelement (12) eine Vielzahl an Halbleiterchips (11, 13) umfasst,
- der Verbindungsträger (9) in Draufsicht eine rechteckige Form aufweist,
- und die Halbleiterchips (11, 13) in Zeilen und/oder Spalten angeordnet sind.

13. Verfahren nach Anspruch 10, bei dem
- das strahlungsemittierende Bauelement eine Vielzahl an Halbleiterchips (11, 13),
- der Verbindungsträger (9) in Draufsicht eine sechseckige Form aufweist, und
- die Halbleiterchips (11, 13) mit jeweils einer Seitenfläche parallel zu einer Seitenfläche des Verbindungsträgers (9) angeordnet sind.

14. Verfahren nach einem der obigen Ansprüche, bei dem das strahlungsemittierende Bauelement (12) zumindest einen elektronischen Halbleiterchip aufweist, der als Sensor (13) ausgebildet ist, wobei der Sensor (13) im Betrieb infrarote Strahlung, eine Temperatur und/oder eine Helligkeit zu detektiert oder zur Bildaufnahme eingerichtet ist.

## Claims

1. A method of manufacturing a plurality of radiation emitting devices (12), comprising the steps of:
- providing a compound (6) with a plurality of connection carriers (9), wherein
- each connection carrier (9) comprises a light-transmissive matrix (7), in which vias (8) are arranged extending therethrough from a first main surface of the connection carrier (9) to a second main surface of the connection carrier (9), and
- the connection carriers (9) are spaced from each other by frames (4) surrounding each connection carrier (9),
- arranging a radiation-emitting semiconductor chip (11) on two vias (8), and
- separating the devices (12) by removing the frames (4) completely or partially.

2. Method according to the previous claim,
wherein providing the compound (6) comprises the following steps:
- providing a semiconductor wafer (1),
- structuring the semiconductor wafer (1) with recesses (2) starting from a first main surface, wherein posts (3) are arranged in the recesses (2), and
- filling the recesses (2) with glass by melting a glass wafer (5) so that the compound (6) is formed.

3. Method according to the previous claim,
wherein the compound (6) is thinned so as to form the plurality of connection carriers (9).

4. Method according to the previous claim,
wherein electrical connection points (10) are arranged on the vias (8).

5. Method according to any of the previous claims,
wherein the frames (4) are completely or partially removed by etching.

6. Method according to any of the previous claims,
wherein
- electrical connection points (10) are arranged on the vias (8) before etching,
- the frames (4) are completely or partially removed by isotropic etching using a gas or a liquid, wherein no additional lithographic mask is used, and
- side surfaces of the connection carriers (9) are formed entirely from the matrix (7).

7. Method according to any of claims 1 to 5, wherein
- the frames (4) are completely or partially removed by anisotropic etching using a mask, and
- the vias (8) partially form the side surfaces of the connection carriers (9).

8. Method of manufacturing a plurality of spatially separated connection carriers (9), comprising the following steps:
- providing a compound (6) with a plurality of connection carriers (9), wherein
- each connection carrier (9) comprises a light-transmissive matrix (7), in which vias (8) are arranged extending therethrough from a first main surface of the connection carrier (9) to a second main surface of the connection carrier (9), and
- the connection carriers (9) are spaced apart from each other by frames (4) which completely surround each connection carrier (9),
- separating the connection carriers (9) by completely or partially removing the frames (4).

9. Method according to any of the previous claims, wherein the radiation emitting device (12) comprises at least one red emitting semiconductor chip (11R), at least one green emitting semiconductor chip (11G) and at least one blue emitting semiconductor chip (11B) on the connection carrier (9).

10. Method according to any of the previous claims,
wherein an electrical connection point (10) is applied to each via (8), which is electrically conductively connected to the semiconductor chip (11, 13), the semiconductor chip (11, 13) covering the electrical connection points (10).

11. Method according to any of the previous claims,
wherein the connection carrier (9) has a hexagonal shape or rectangular shape in plan view.

12. Method according to any of the previous claims,
wherein
- the radiation emitting device (12) comprises a plurality of semiconductor chips (11, 13),
- the connection carrier (9) has a rectangular shape in plan view,
- and the semiconductor chips (11, 13) are arranged in rows and/or columns.

13. Method according to claim 10, wherein
- the radiation emitting device comprises a plurality of semiconductor chips (11, 13),
- the connection carrier (9) has a hexagonal shape in plan view, and
- the semiconductor chips (11, 13) are each arranged with a side surface parallel to a side surface of the connection carrier (9).

14. Method according to any of the previous claims,
wherein the radiation-emitting device (12) has at least one electronic semiconductor chip, which is designed as a sensor (13), the sensor (13) detecting infrared radiation, a temperature and/or a brightness during operation or being set up for image recording.

## Revendications

1. Procédé de fabrication d'une pluralité de composants émetteurs de rayonnement (12), comprenant les étapes suivantes:
- Fournir un composite (6) comprenant une pluralité de support de connexion (9), dans lequel
- chaque supports de connexion (9) comprend une matrice transmettant la lumière (7) dans laquelle sont disposés des trous d'interconnexion (8) qui s'étendent d'une première surface principale du support de connexion (9) à une deuxième surface principale du support de connexion (9), et
- les supports de connexion (9) sont espacés les uns des autres par des cadres (4) qui entourent chaque support de connexion (9),
- la mise en place d'une puce semi-conductrice émettrice de rayonnement (11) sur deux trous d'interconnexion (8), et
- Séparer les composants (12) en enlevant tout ou partie des cadres (4).

2. Procédé selon la revendication précédente,
dans lequel la fourniture du composite (6) comprend les étapes suivantes:
- fournir une plaquette semi-conductrice (1),
- structurer la plaquette semi-conductrice (1) avec des évidements (2) en partant d'une première surface principale, des montants (3) étant disposés dans les évidements (2), et
- remplissage des évidements (2) avec du verre par fusion d'une plaquette de verre (5) de manière à former le composite (6) .

3. Procédé selon la revendication précédente,
dans lequel le composite (6) est aminci de manière à obtenir la pluralité de supports de connexion (9).

4. Procédé selon la revendication précédente,
dans lequel des points de connexion électrique (10) sont disposés sur les trous d'interconnexion (8).

5. Procédé selon l'une quelconque des revendications précédentes,
dans lequel les cadres (4) sont entièrement ou partiellement retirés par gravure.

6. Procédé selon l'une quelconque des revendications précédentes, dans lequel
- avant la gravure, des points de connexion électrique (10) sont disposés sur les trous d'interconnexion (8),
- les cadres (4) sont éliminés totalement ou partiellement par gravure isotrope à l'aide d'un gaz ou d'un liquide, sans utiliser de masque lithographique supplémentaire, et
- les surfaces latérales des supports de connexion (9) sont entièrement formées de la matrice (7).

7. Procédé selon l'une quelconque des revendications 1 à 5, dans lequel
- les cadres (4) sont entièrement ou partiellement retirés par gravure anisotrope en utilisant un masque, et
- les trous d'interconnexion (8) forment partiellement les surfaces latérales des supports de connexion (9).

8. Procédé de fabrication d'une pluralité de supports de connexion (9) séparés dans l'espace les uns des autres, comprenant les étapes suivantes:
- Préparation d'un composite (6) avec une pluralité de supports de connexion (9), dans lequel
- chaque support de connexion (9) comprend une matrice transmettant la lumière (7) dans laquelle sont disposés des trous d'interconnexion (8) qui s'étendent d'une première surface principale du support de connexion (9) à une deuxième surface principale du support de connexion (9), et
- les supports de connexion (9) sont espacés les uns des autres par des cadres (4) qui entourent complètement chaque support de connexion (9),
- séparer les supports de connexion (9) en enlevant complètement ou partiellement les cadres (4).

9. Procédé selon l'une quelconque des revendications
précédentes, dans lequel le composant émetteur de rayonnement (12) comprend au moins une puce semi-conductrice émettant dans le rouge (11R), au moins une puce semi-conductrice émettant dans le vert (11G) et au moins une puce semi-conductrice émettant dans le bleu (11B) sur le support de connexion (9).

10. Procédé selon l'une quelconque des revendications précédentes,
dans lequel on applique sur chaque trou d'interconnexion (8) un point de connexion électrique (10) qui est relié de manière électriquement conductrice à la puce semi-conductrice (11, 13), la puce semi-conductrice (11, 13) recouvrant les points de connexion électrique (10).

11. Procédé selon l'une quelconque des revendications précédentes,
dans lequel le support de connexion (9) présente, en vue de dessus, une forme hexagonale ou une forme rectangulaire.

12. Procédé selon l'une quelconque des revendications précédentes, dans lequel
- le composant émetteur de rayonnement (12) comprend une pluralité de puces semi-conductrices (11, 13),
- le support de connexion (9) présente une forme rectangulaire en vue de dessus,
- et les puces semi-conductrices (11, 13) sont disposées en lignes et/ou en colonnes.

13. Procédé selon la revendication 10, dans lequel
- le composant émetteurs de rayonnement comprend une pluralité de puces semi-conductrices (11, 13),
- le support de connexion (9) présente une forme hexagonale en vue de dessus, et
- les puces semi-conductrices (11, 13) sont disposées avec une surface latérale respective parallèle à une surface latérale du support de connexion (9).

14. Procédé selon l'une quelconque des revendications précédentes, dans lequel le composant émetteur de rayonnement (12) comporte au moins une puce électronique à semi-conducteur qui est conçue comme un capteur (13), le capteur (13) détectant en fonctionnement un rayonnement infrarouge, une température et/ou une luminosité ou étant conçu pour prendre une image.
